# EUROPÄISCHE PATENTANMELDUNG

(11) **EP 3 073 624 A1**
(43) Veröffentlichungstag der Anmeldung: **28.09.2016**
(21) Anmeldenummer: 15161447.6
(22) Anmeldetag: 27.03.2015
(51) Int. Cl.: H02M 1/12, H03H 7/01

(54) **Netzfilter für Umrichter**

(71) Anmelder: Siemens Aktiengesellschaft, 80333 München (DE)
(72) Erfinder: Höhne, Silvio, 91056 Erlangen (DE); Kürten, Bernd, 90587 Obermichelbach (DE)

(57) **Zusammenfassung**

Die Erfindung ist ein Umrichterfilter (10) mit einer Drossel (12) und zumindest einem ersten und einem zweiten an die Drossel (12) gekoppelten Saugkreis (14,16), wobei der erste und der zweite Saugkreis (14,16) mittels der Induktivität einer Teilwicklung (26) der Drossel (12) oder mittels einer an die Drossel (12) gekoppelten Hilfswicklung (28) voneinander entkoppelt sind, wobei die Hilfswicklung (28) mit der Teilwicklung (26) einen 1:1-Übertrager bildet und mittels der Induktivität der Teilwicklung (26) gespeist wird.

## Beschreibung

Die Erfindung betrifft einen Netzfilter für einen Umrichter oder allgemein einen Filter für einen Umrichter, also einen eingangsseitig oder ausgangsseitig des Umrichters verwendbaren Filter.

Umrichter erzeugen ein speziell am Netzeingang unerwünschtes Störspektrum, das überwiegend Oberschwingungen ihrer Schaltfrequenz enthält. Zur Vermeidung störender Rückwirkungen auf das speisende Netz werden die jeweils resultierenden Störspannungen mittels eines Filters oder einer Filteranordnung bedämpft, und zwar bevorzugt so weit bedämpft, dass diese nicht mehr störend in Erscheinung treten, sie also herausgefiltert werden. Bei einer solchen Filteranordnung handelt es sich üblicherweise um mehrstufige sogenannte Saugkreise, die zwischen der Netzdrossel des Umrichters und dem Netzeingang angeordnet sind. Innerhalb einer solchen Filteranordnung müssen die Saugkreise voneinander entkoppelt werden. Dazu werden zusätzlich zu der Netzdrossel weitere Induktivitäten zwischen den Saugkreisen verwendet. Durch die zusätzlichen Induktivitäten fließt jeweils der volle Strom, mit dem der Umrichter gespeist wird. Die zusätzlichen Induktivitäten müssen also dieselbe Stromtragfähigkeit aufweisen wie die Netzdrossel und es resultieren aufgrund der zusätzlichen Induktivitäten ein entsprechender Raumbedarf sowie entsprechende Bauteilkosten.

Bisherige Filteranordnungen für einen Umrichter sind demnach insofern verbesserungsfähig, als die für die Ankopplung der Saugkreise benötigten zusätzlichen Induktivitäten wegen der notwendigen Stromtragfähigkeit, nämlich der Notwendigkeit, dass diese für den Maximalstrom des Umrichters ausgelegt sind, teuer sind und einen großen Raumbedarf haben.

Eine Aufgabe der vorliegenden Erfindung besteht entsprechend darin, einen Netzfilter oder allgemein eine Filteranordnung für einen Umrichter anzugeben, bei dem bzw. bei der die oben genannten Nachteile vermieden werden oder zumindest deren Auswirkungen reduziert sind.

Diese Aufgabe wird erfindungsgemäß mit einer im Folgenden als Umrichterfilter bezeichneten Filteranordnung für einen Umrichter mit den Merkmalen des Anspruchs 1 gelöst. Dabei ist bei einem solchen Umrichterfilter, der eine Netzdrossel und zumindest einen ersten und einen zweiten an die Netzdrossel gekoppelten Saugkreis umfasst, vorgesehen, dass der erste und der zweite Saugkreis mittels einer Teilwicklung der Netzdrossel, nämlich einer Induktivität der Teilwicklung der Netzdrossel, voneinander entkoppelt sind.

Die zumindest zwei Saugkreise können im einfachsten Fall in Form eines Kondensators, aber auch komplexer und zum Beispiel in Form eines Serienschwingkreises realisiert sein und sind auf ein zu filterndes Störspektrum abgestimmt. Der erste und der zweite Saugkreis sind zum Beispiel auf 8kHz bzw. 16kHz abgestimmt. Durch jeden Saugkreis fließt nur der Strom, der durch das jeweilige Störspektrum verursacht wird, auf das der Saugkreis abgestimmt ist. Dieser ist um eine Größenordnung (Zehnerpotenz) niedriger als der durch die Drossel fließende Strom, also bei einer als Netzdrossel fungierenden Drossel der den Umrichter speisende Strom.

Ein geringer Teil einer Störung, die zum Beispiel mittels eines an einen Zwischenabgriff der Drossel angeschlossenen Saugkreises abgeführt wird, wird in die oder jede nachfolgende Teilwicklung wieder eingekoppelt. Die Filterwirkung ist also nicht optimal. Dennoch wird ein ausreichender Filtereffekt erzielt, indem das Verhältnis der Windungen der Teilwicklung zu den verbleibenden Windungen der Drossel geeignet gewählt wird, zum Beispiel derart, dass sich ein Verhältnis 1:10, 1:20 oder 1:50 usw. ergibt. Aufgrund eines solchen Windungsverhältnisses wird nur ein Bruchteil, der über einen Saugkreis abgeleiteten Störung wieder eingekoppelt, bei einem Windungsverhältnis von 1:10 ergibt sich zum Beispiel nur eine Einkopplung von etwa 10% der abgeleiteten Störung. Dies hat sich als vertretbar herausgestellt und bei anderen Windungsverhältnissen resultiert eine noch geringere Einkopplung.

Der Vorteil der Erfindung besteht darin, dass nur die Drossel/Netzdrossel für den Maximalstrom des Umrichters ausgelegt sein muss und dass diese ohnehin für diesen Maximalstrom ausgelegt ist. Dies und das damit einhergehende Einsparpotential wiegt die zudem noch durch das Windungsverhältnis beeinflussbare Einkopplung einer mittels eines Saugkreises abgeleiteten Störung mehr als auf. Anstelle zusätzlicher Induktivitäten wird die Entkopplung der Saugkreise mittels einer Teilwicklung der Drossel selbst erzielt, zum Beispiel durch einen Zwischenabgriff an der Drossel. Aufgrund eines derartigen Abgriffs ergibt sich eine zur Entkopplung der Saugkreise elektrisch wirksame Teilwicklung, wobei die Induktivität der Teilwicklung die Entkopplung bewirkt. Eine zusätzliche Induktivität mit der vollen Stromtragfähigkeit in Form eines eigenständigen Bauteils wird also nicht benötigt.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Bei einer besonderen Ausführungsform des Umrichterfilters ist mit der Drossel eine Hilfswicklung gekoppelt. Für die Hilfswicklung sind einige wenige Windungen ausreichend, zum Beispiel eine Windung oder sogar eine halbe Windung und bis zu ca. 10% der Windungen der Drossel. Die Hilfswicklung bildet mit der entsprechenden jeweiligen Anzahl von Windungen der Drossel einen 1:1-Übertrager. Die zu dem Übertrager gehörenden Windungen der Drossel entsprechen der oben genannten Teilwicklung der Drossel. Ein spezieller Abgriff zur Kontaktierung der Teilwicklung ist aufgrund der Hilfswicklung und deren (magnetischer) Ankopplung an die Teilwicklung nicht mehr erforderlich. Die Saugkreise sind mittels der Selbstinduktivität der Hilfswicklung und der Gegeninduktivität zwischen Hilfs- und Hauptwicklung voneinander entkoppelt. Ursächlich für die Gegeninduktivität ist die magnetische Kopplung von Hilfswicklung zu Haupt- und Teilwicklung. Damit rechtfertigt sich, auch bei einem Umrichterfilter mit einer an die Drossel gekoppelten Hilfswicklung von einer Entkopplung der Saugkreise mittels der Induktivität einer Teilwicklung der Drossel zu sprechen.

Diese Ausführungsform des Umrichterfilters nutzt den bereits erwähnten Umstand, dass durch die einzelnen Saugkreise lediglich der Strom fließt, der durch das jeweilige Störspektrum verursacht wird, auf das der Saugkreis abgestimmt ist. Dieser ist zumindest um eine Größenordnung (Zehnerpotenz) niedriger als der durch die Drossel fließende Strom, also bei einer als Netzdrossel fungierenden Drossel der den Umrichter speisende Strom. Die Hilfswicklung kann damit hinsichtlich ihrer Stromtragfähigkeit deutlich kleiner dimensioniert sein. Aufgrund dessen ist einer Kombination der Hilfswicklung mit der Drossel leicht möglich.

Bei einer speziellen Ausführungsform eines Umrichterfilters mit einer Hilfswicklung sind die Hilfswicklung und die Kombination der Hilfswicklung mit der Drossel das Ergebnis eines Zurückwickelns eines Leiters vom Ausgang der Drossel. Die Drossel und die Hilfswicklung bilden demnach zusammen ein dreipoliges elektrisches Bauteil, das elektrisch einer Drossel mit einem Zwischenabgriff entspricht.

Wenn die Hilfswicklung derart mit der Drossel kombiniert ist, dass die Hilfswicklung in einem für die Einhaltung von Luftund Kriechstrecken üblicherweise zwischen der Wicklung und dem Drosselkern freizuhaltenden Wickelraum der Drossel platziert ist, resultiert aufgrund der Hilfswicklung kein zusätzlicher Platzbedarf. Eine Schaltung oder ein elektrisches Gerät mit einem derartigen Umrichterfilter kann also räumlich entsprechend klein dimensioniert werden.

Bei einer solchen Platzierung der Hilfswicklung im Wickelraum der Drossel kommt die Verwendung eines sich aus mehreren Materialen zusammensetzenden Isoliersystems für den die Hilfswicklung bildenden Leiter in Betracht, um eine jeweils angestrebte Durchschlagsfestigkeit, Hitzebeständigkeit und/oder Lebensdauer zu gewährleisten.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Es zeigen
- FIG 1: eine erste Ausführungsform der hier vorgeschlagenen Filteranordnung und
- FIG 2: eine weitere Ausführungsform der hier vorgeschlagenen Filteranordnung.

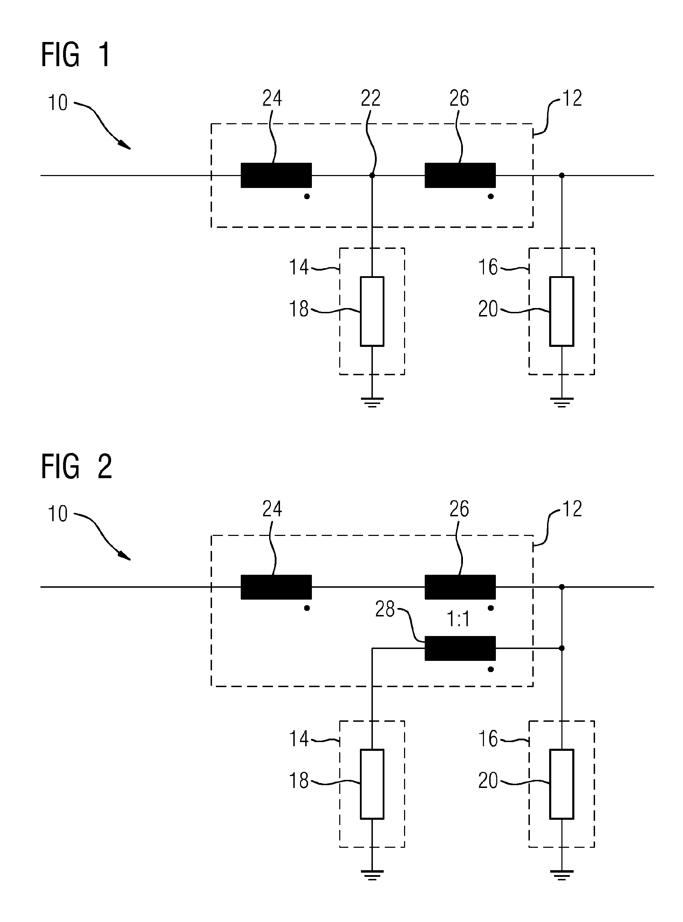

Die Darstellung in FIG 1 zeigt eine erste Ausführungsform der hier vorgeschlagenen Filteranordnung. Diese wird hier und im Folgenden als Umrichterfilter 10 bezeichnet. Zu dem Umrichterfilter 10 gehören eine Drossel 12 und zumindest zwei im Folgenden zur Unterscheidung als erster Saugkreis 14 und als zweiter Saugkreis 16 bezeichnete Saugkreise 14, 16. Die Drossel 12 fungiert bei einer Verwendung des Umrichterfilters 10 als Netzfilter als Netzdrossel 12. Der Umrichterfilter 10 kommt auch für eine Verwendung als lastseitiger Filter in Betracht und fungiert dann zum Beispiel als Motorfilter.

Die beiden gezeigten Saugkreise 14, 16 umfassen im einfachsten Fall einen Kondensator, können aber auch komplexer aufgebaut und zum Beispiel in Form eines Serienschwingkreises realisiert sein. Dargestellt ist dies in Form jeweils eines Wechselstromwiderstands 18, 20.

Bekanntlich ist ein Saugkreis 14, 16 ein üblicherweise gegen Masse geschalteter Zweipol mit einem möglichst geringen ohmschen Widerstand und einem im Bereich einer Resonanzfrequenz besonders geringen Gesamtwiderstand. Die jeweilige Resonanzfrequenz des Saugkreises 14, 16 ergibt sich aufgrund einer entsprechenden Dimensionierung des Kondensators oder weiterer Bauteile. Mittels einer derartigen Dimensionierung kann der Saugkreis 14, 16 auf eine in der Schaltung, an die er angeschlossen ist, zu löschende Frequenz abgestimmt werden, hier die Schaltung mit dem Umrichter. Im Falle eines Anschlusses des Saugkreises 14, 16 gegen Masse ergibt sich für die jeweilige Resonanzfrequenz ein selektiver Masseschluss. Die (störende) Resonanzfrequenz wird in der Schaltung, an die der Saugkreis 14, 16 angeschlossen ist, gelöscht, also aufgrund der Ableitung gegen Masse gewissermaßen aus der Schaltung herausgesogen.

Zum Anschluss des ersten Saugkreises 14 ist ein Zwischenabgriff 22 an der Drossel 12 vorgesehen. Bei mehr als zwei Saugkreisen 14, 16, werden zusätzliche, hier nicht gezeigte Zwischenabgriffe der Drossel 12 geschaffen und verwendet. Aufgrund des zumindest einen Zwischenabgriffs 22 an der Drossel 12 teilt sich diese vom Ort des Abgriffs aus gesehen gewissermaßen in eine Hauptwicklung 24 und eine Teilwicklung 26 auf. Wichtig ist, sich dabei zu vergegenwärtigen, dass die Hauptwicklung 24 und die Teilwicklung 26 zusammen die Drossel 12 bilden und dass es sich nicht um zwei eigenständige Bauelemente handelt. Die getrennte Darstellung ist hier lediglich erfolgt, um den Zwischenabgriff 22 darzustellen.

Die aufgrund des Zwischenabgriffs 22 separat kontaktierbare Teilwicklung 26 gewährleistet die notwendige Entkopplung der beiden Saugkreise 14, 16 voneinander, ohne dass dafür eine zusätzliche Induktivität in Form eines von der Drossel 12 unabhängigen und mit der Drossel 12 in Reihe geschalteten Bauteils mit derselben Stromtragfähigkeit wie die Drossel 12 notwendig wird.

Der Zwischenabgriff 22 oder auch mehrere Zwischenabgriffe 22 löst bzw. lösen das Problem, dass bisher zur Entkopplung mehrerer Saugkreise 14, 16 mit der Drossel 12 in Reihe geschaltete Induktivitäten benötigt werden, die wie die Drossel 12 selbst jeweils für den Maximalstrom des Umrichters ausgelegt sind. Allerdings ist ein Zwischenabgriff 22 an der Drossel 12 nicht einfach zu realisieren. Ein Zwischenabgriff 22 stört den homogenen Wicklungsaufbau der Drossel 12 und kostet Platz.

Bei einer speziellen Ausführungsform des hier vorgeschlagenen und ohne zusätzliche Induktivitäten mit voller Stromtragfähigkeit auskommenden Umrichterfilters 10 ist daher eine Hilfswicklung 28 vorgesehen. Diese Hilfswicklung ist zusammen mit der Drossel 12 und den exemplarisch zwei Saugkreisen 14, 16 gemäß FIG 1 in der Darstellung in FIG 2 gezeigt.

Die Hilfswicklung 28 ist eine elektrisch gleichwertige Lösung zu einem Zwischenabgriff 22 und einer damit kontaktierbaren Teilwicklung 26 der Drossel 12. An die Hilfswicklung 28 ist der zuvor (vgl. FIG 1) an den Zwischenabgriff 22 angeschlossene erste Saugkreis 14 angeschlossen. Die Hilfswicklung 28 bewirkt die Entkopplung der beiden Saugkreise 14, 16.

Die Hilfswicklung 28 ergibt sich zum Beispiel durch ein "Zurückwickeln" eines Leiters vom Ausgang der Drossel 12. Die Hilfswicklung 28 umfasst nur einige wenige Windungen. Bei der Erprobung hat sich herausgestellt, dass eine einzelne Windung ausreicht. Eine höhere Anzahl von Windungen ist gleichwohl ebenso möglich.

Die Hilfswicklung 28 ist mit einer der Anzahl der Windungen der Hilfswicklung 28 entsprechenden Anzahl von Windungen der Drossel 12 (Teilwicklung 26) in Form eines 1:1-Übertragers gekoppelt. Die insoweit wirksame Teilwicklung 26 erzeugt eine Gegeninduktivität in der Hilfswicklung 28. Damit rechtfertigt sich die Definition des Umrichterfilters 10, wonach der erste und der zweite Saugkreis 14, 16 mittels der Selbstinduktivität einer Teilwicklung 26 der Drossel 12 und der Gegeninduktivität zwischen Haupt- und Teilwicklung voneinander entkoppelt sind. Bei der in FIG 2 gezeigten speziellen Ausführungsform wird diese Entkopplung konkret mit der an die Teilwicklung 26 gekoppelten Hilfswicklung 28 und deren induktiver Kopplung erreicht.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen: Angegeben wird ein Umrichterfilter 10 mit einer Drossel 12 und zumindest einem ersten und einem zweiten an die Drossel 12 gekoppelten Saugkreis 14, 16, wobei der erste und der zweite Saugkreis 14, 16 mittels der Induktivität einer Teilwicklung 26 der Drossel 12 oder mittels einer an die Drossel 12 gekoppelten Hilfswicklung 28 voneinander entkoppelt sind, wobei die Hilfswicklung 28 mit der Teilwicklung 26 einen 1:1-Übertrager bildet und mittels der Induktivität der Teilwicklung 26 gespeist wird.

## Patentansprüche

1. Umrichterfilter (10) mit einer Drossel (12) und zumindest einem ersten und einem zweiten an die Drossel (12) gekoppelten Saugkreis (14,16), wobei der erste und der zweite Saugkreis (14,16) mittels der Induktivität einer Teilwicklung (26) der Drossel (12) voneinander entkoppelt sind.

2. Umrichterfilter (10) nach Anspruch 1, wobei mit der Drossel (12) eine Hilfswicklung (28) gekoppelt ist, die mit der Teilwicklung (26) einen 1:1-Übertrager bildet und mittels der Induktivität der Teilwicklung (26) gespeist wird, wobei der erste Saugkreis (14) an die Hilfswicklung (28) angeschlossen ist.

3. Umrichterfilter (10) nach Anspruch 2, wobei die Hilfswicklung (28) Ergebnis eines Zurückwickelns eines Leiters vom Ausgang der Drossel (12) ist.

4. Umrichterfilter (10) nach Anspruch 2 oder 3, wobei die Hilfswicklung (28) in einem für die Einhaltung von Luft- und Kriechstrecken üblicherweise zwischen der Wicklung und dem Drosselkern freizuhaltenden Wickelraum der Drossel (12) platziert ist.

5. Schaltung oder elektrisches Gerät, in dem ein Umrichterfilter (10) nach einem der Ansprüche 1 bis 4 am Eingang eines Umrichters als Netzfilter fungiert.

6. Schaltung oder elektrisches Gerät, in dem ein Umrichterfilter (10) nach einem der Ansprüche 1 bis 4 am Ausgang eines Umrichters als ausgangsseitiger Filter fungiert.
